# EUROPÄISCHE PATENTANMELDUNG

(11) **EP 4 446 086 A1**
(43) Veröffentlichungstag der Anmeldung: **16.10.2024**
(21) Anmeldenummer: 23167761.8
(22) Anmeldetag: 13.04.2023
(51) Int. Cl.: B29C 45/14, H05K 5/06, B29K 21/00, B29K 75/00, B29C 45/77, B29C 45/78, B29K 63/00

(54) **GEHÄUSESCHALE UND KUNSTSTOFFSPRITZGUSSVERFAHREN ZUR HERSTELLUNG EINES ELEKTRISCHEN VERTEILERS MIT EINER GEHÄUSESCHALE**

(71) Anmelder: WWS Technik in Form und Kunststoff GmbH, 71570 Oppenweiler (DE)
(72) Erfinder: Wolf, Joachim, 71570 Oppenweiler (DE)
(74) Vertreter: Karzel, Philipp

(57) **Zusammenfassung**

Die Erfindung betrifft eine Gehäuseschale zur Aufnahme eine Leiterplatte (2) mit passiven und/oder aktiven elektrischen Bauelementen (3) und zur Aufnahme von Füllmaterial (4) aus einer Spritzgussmasse aus thermoplastischem Elastomer. Die Gehäuseschale (1) besteht aus einem Kunststoffmaterial und ist dafür ausgelegt, dass das Füllmaterial (4) aus Spritzgussmasse aus einem thermoplastischen Elastomer mit einer Temperatur von mindestens 170°C und mit einem Druck von mindestens 100 bar in die Gehäuseschale (1) beschädigungslos einspritzbar ist, so dass sich die Spritzgussmasse fest mit der Gehäuseschale (1) verbindet und die Gehäuseschale (1) formstabil bleibt. Die Gehäuseschale (1) weist eine Gehäuseaußenwand (5) auf, in der Durchdringungsöffnungen (6) für Steckkontakte (7) vorgesehen sind. Die Gehäuseaußenwand (5) der Gehäuseschale (1) ist mit Ausnahme der Durchdringungsöffnungen (6) für die Stecckontakte (7) frei von Durchgangsöffnungen.

## Beschreibung

Die Erfindung betrifft eine Gehäuseschale nach dem Oberbegriff des Anspruchs 1 und ein Kunststoffspritzgussverfahren zur Herstellung eines elektrischen Verteilers mit einer Gehäuseschale nach dem Oberbegriff des Anspruchs 15.

Aus der EP 2 958 409 B1 ist eine Gehäuseschale eines elektrischen Verteilers bekannt, die dafür ausgelegt ist, Füllmaterial aus einer Spritzgussmasse aus thermoplastischem Elastomer mit einer Temperatur von mindestens 170°C und mit einem Druck von mindestens 100 bar während eines Einspritzverfahrensschritts beschädigungslos aufzunehmen. Die Gehäuseaußenwand der Gehäuseschale umfasst Durchdringungsöffnungen für Steckkontakte. An der Gehäuseaußenwand sind topfförmige Aufnahmen zur Aufnahme von Steckköpfen ausgebildet. Die Durchdringungsöffnungen für die Steckkontakte sind am Boden der Aufnahmen ausgebildet. Die Steckkontakte ragen durch die Gehäuseaußenwand durch den Boden der topfförmigen Aufnahme aus dem Innenraum der Gehäuseschale nach außen hervor. Zwischen dem Boden der topfförmigen Aufnahme und dem Steckkopf ist eine aus Spritzgussmasse bestehende Abdichtung gebildet, die zur Abdichtung des Verteilers gegenüber dem Steckkopf dient. Zur Herstellung der ringförmigen Abdichtung im Spritzgussverfahren sind im Boden der topfförmigen Aufnahme Durchflussöffnungen für die Spritzgussmasse vorgesehen.

Die Abdichtung der elektrischen Bauelemente einer Leiterplatte, die in der Gehäuseschale angeordnet ist, mittels einer Spritzgussmasse aus thermoplastischem Elastomer ist erst ab einer gewissen Stückzahl an herzustellenden elektrischen Verteilern rentabel. In der Regel muss die Gehäuseschale an spezielle Bedürfnisse des herzustellenden elektrischen Verteilers angepasst werden. Oft muss auch ein neues Spritzgusswerkzeug hergestellt werden. Für kleinere Stückzahlen an herzustellenden elektrischen Verteilern lohnt sich i.d.R. eher die Abdichtung und elektrische Isolierung der auf der Leiterplatte angeordneten elektrischen Bauelemente mittels einer Vergussmasse aus einem Harz. Hierfür ist die Gehäuseschale zur Aufnahme von Füllmaterial aus einer Spritzgussmasse aus thermoplastischem Elastomer jedoch nicht geeignet.

Der Erfindung liegt die Aufgabe zugrunde, eine gattungsgemäße Gehäuseschale derart weiterzubilden, dass sie flexibel für verschiedene Anwendungen einsetzbar ist.

Diese Aufgabe wird durch eine Gehäuseschale mit den Merkmalen des Anspruchs 1 gelöst.

Eine weitere Aufgabe der Erfindung liegt darin, ein Kunststoffspritzgussverfahren zur Herstellung eines elektrischen Verteilers anzugeben, bei dem die verwendete Gehäuseschale für verschiedene Anwendungen einsetzbar ist.

Diese Aufgabe wird durch ein Kunststoffspritzgussverfahren mit den Merkmalen des Anspruchs 15 gelöst.

Die erfindungsgemäße Gehäuseschale zur Aufnahme einer Leiterplatte mit passiven und/oder aktiven elektrischen Bauelementen und zur Aufnahme von Füllmaterial aus einer Spritzgussmasse aus thermoplastischem Elastomer besteht aus einem Kunststoffmaterial und ist dafür ausgelegt, dass das Füllmaterial aus Spritzgussmasse aus dem thermoplastischen Elastomer mit einer Temperatur von mindestens 170°C und mit einem Druck von mindestens 100 bar in die Gehäuseschale beschädigungslos einspritzbar ist, so dass sich die Spritzgussmasse fest mit der Gehäuseschale verbindet und die Gehäuseschale formstabil bleibt. Die Gehäuseschale weist eine Gehäuseaußenwand auf, in der Durchdringungsöffnungen für Steckkontakte vorgesehen sind. Erfindungsgemäß ist die Gehäuseaußenwand der Gehäuseschale mit Ausnahme der Durchdringungsöffnungen für die Steckkontakte frei von Durchgangsöffnungen. Insbesondere ist die Gehäuseaußenwand der Gehäuseschale mit Ausnahme der Durchdringungsöffnungen für Steckkontakte geschlossen. Dadurch ist die Gehäuseschale flexibel einsetzbar. Sie kann sowohl in einem Kunststoffspritzgussverfahren mit einem Füllmaterial aus einer Spritzgussmasse aus thermoplastischem Elastomer als auch zum Verguss von Vergussmasse aus Harz, insbesondere aus Epoxidharz, bevorzugt aus Polyurethanharz, in die Gehäuseschale verwendet werden. Dadurch können baugleiche Gehäuseschale in verschiedenen Anwendungsbereichen eingesetzt werden. Die Gehäuseschale kann als Massenprodukt hergestellt werden. Je nach erforderlicher Stückzahl kann die Gehäuseschale in einem Spritzgussverfahren mit Spritzgussmasse aus thermoplastischem Elastomer oder in einem Vergussverfahren mit Vergussmasse aus Harz verwendet werden. Dies erspart Lagerkosten für verschiedenartige Bauteile und Herstellungskosten von Gehäuseschalen mit verschiedenen Spritzgusswerkzeugen.

Der Grund dafür, dass die Gehäuseschale sowohl in einem Vergussverfahren mit Harz als Vergussmasse, als auch in einem Spritzgussverfahren mit einer Spritzgussmasse aus thermoplastischem Elastomer verwendet werden kann, liegt darin, dass die Gehäuseaußenwand der Gehäuseschale mit Ausnahme der Durchdringungsöffnungen für Stecckontakte frei von Durchgangsöffnungen ist. Dadurch ist verhindert, dass Vergussmasse aus Harz, das eine vergleichsweise geringe Viskosität aufweist, aus der Gehäuseschale austreten kann. Ein Tropfen der Vergussmasse aus Harz durch Durchgangsöffnungen aus der Gehäuseschale heraus ist zuverlässig unterbunden. Die Durchdringungsöffnungen für die Steckkontakte sind beim Vergießen der Vergussmasse durch die Steckkontakte ausgefüllt. Dadurch kann durch die Durchdringungsöffnungen für die Steckkontakte keine Vergussmasse aus der Gehäuseschale austreten. Die Gehäuseschale kann für sich genommen als Schale verwendet werden, in die Vergussmasse aus Harz direkt eingegossen wird.

Der Erfindung liegt die Erkenntnis zugrunde, dass die Abdichtung zwischen der Gehäuseschale und dem Steckkopf zu Lasten der flexiblen Einsetzbarkeit der Gehäuseschale mittels einer durch Durchflussöffnungen in der Gehäuseaußenwand eingespritzten ringförmigen Abdichtung aus Spritzgussmasse erfolgt. Eine geschlossene Außenwand bietet die Möglichkeit, die Gehäuseschale in einem größeren Einsatzgebiet zu verwenden. Die Abdichtung zwischen Gehäuseschale und Steckkopf kann auch auf andere Weise, beispielsweise durch einen O-Ring, bzw. durch eine Radialdichtung erfolgen. Dadurch, dass in der Gehäuseaußenwand erfindungsgemäß eine geringere Anzahl an Durchgangsöffnungen erforderlich ist, kann die Gehäuseschale einfacher und kostengünstiger hergestellt werden. Das entsprechende Spritzgusswerkzeug ist einfacher und kostengünstiger herzustellen. Die Entformung der Gehäuseschale gestaltet sich unkomplizierter.

Zweckmäßig ist die Gehäuseschale wannenförmig ausgebildet. Insbesondere besitzt die Gehäuseaußenwand einen Boden. Der Boden der Gehäuseaußenwand ist durch ein Bodenelement gebildet. Die Durchdringungsöffnungen für die Steckkontakte sind zweckmäßig im Bodenelement der Gehäuseaußenwand ausgebildet. Dadurch können die Steckkontakte auf besonders einfache Weise mit der Leiterplatte verbunden werden und gleichzeitig aus der Gehäuseaußenwand herausragen.

Vorteilhaft besteht das Material der Gehäuseschale, insbesondere der Gehäuseaußenwand der Gehäuseschale, aus faserverstärktem Polyester. Insbesondere besteht das Material der Gehäuseschale, insbesondere der Gehäuseaußenwand, aus glasfaserverstärktem oder aus kohlefaserverstärktem Polyester. Bevorzugt beträgt der Faservolumenanteil mindestens 10%, insbesondere mindestens 20%. Vorteilhaft beträgt der Faservolumenanteil höchstens 50%, insbesondere höchstens 40%. Insbesondere besteht das Material der Gehäuseschale, insbesondere der Gehäuseaußenwand, aus einem faserverstärkten Gemisch aus zwei oder mehreren Polymeren, insbesondere aus einem Gemisch aus Polycarbonat (PC) und Polybutylenterephthalat (PBT). Zweckmäßig ist das Material der Gehäuseschale, insbesondere der Gehäuseaußenwand, 30% glasfaserverstärktes Polycarbonat/Polybutylenterephthalat (PC/PBT) Harz. Dieses Material weist eine reduzierte Schrumpfung auf. Insbesondere besitzt das Material eine spritzgießbare Qualität. Zweckmäßig ist das Material bromiert. Insbesondere ist das Material flammhemmend. Vorteilhaft besitzt das Material der Gehäuseschale, insbesondere der Gehäuseaußenwand, eine Schmelztemperatur von mindestens 230°C, insbesondere von mindestens 240°C.

Insbesondere besitzt das Material der Gehäuseschale, insbesondere der Gehäuseaußenwand, eine Vicat-Erweichungstemperatur, Rate A/50, von mindestens 200°C. Vorteilhaft besitzt das Material der Gehäuseschale, insbesondere der Gehäuseaußenwand, eine Vicat-Erweichungstemperatur, Rate B/50, von mindestens 150°C. Dadurch ist während des Einspritzens des Füllmaterials aus einem thermoplastischen Elastomer mit einer Temperatur von mindestens 170°C und einem Druck von mindestens 100 bar in die Gehäuseschale eine ausreichende Formstabilität, insbesondere eine ausreichende Dimensionstreue und/oder Maßhaltigkeit, der Gehäuseschale gegeben.

Zweckmäßig weist die Gehäuseschale, insbesondere der elektrische Verteiler Stecckontakte auf. Insbesondere ist durch jede Durchdringungsöffnung ein Steckkontakt gesteckt. Vorteilhaft sind die Durchdringungsöffnungen durch die Steckkontakte ausgefüllt. Dadurch ist sichergestellt, dass beim Vergießen der Vergussmasse aus Harz in die Gehäuseschale keine Vergussmasse aus der Gehäuseschale austreten kann.

Insbesondere ist die Gehäuseschale dafür ausgelegt, mit einem Gießharz ausgegossen zu werden. Das Gießharz kann insbesondere ein Epoxidharz, bevorzugt ein Polyurethanharz sein. Das Gießharz kann insbesondere bei einer Temperatur von weniger als 60°C, insbesondere von weniger als 50°C, bevorzugt von weniger als 40°C vergossen werden. In vorteilhafter Weiterbildung der Erfindung ist vorgesehen, dass die Gehäuseschale einen Grundkörper und mehrere Einsetzmodule umfasst. Die mehreren Einsetzmodule umfassen mindestens ein erstes Einsetzmodul und ein zweites Einsetzmodul. Die mehreren Einsetzmodule sind zweckmäßig getrennt von dem Grundkörper ausgebildet. Vorteilhaft sind die Durchdringungsöffnungen, insbesondere alle Durchdringungsöffnungen, in den mehreren Einsetzmodulen ausgebildet. Durch die Gestaltung der Gehäuseschale, umfassend einen Grundkörper und mehrere Einsetzmodule, kann der Grundkörper der Gehäuseschale immer gleich und unverändert gestaltet sein. Dies erspart Lager- und Herstellungskosten. Die Grundkörper der Gehäuseschale können in großer Stückzahl hergestellt und gelagert werden. Durch die Einsetzmodule ist eine flexible Anpassung an die jeweiligen Erfordernisse auf einfache Weise möglich.

Zweckmäßig sind zumindest das erste Einsetzmodul und das zweite Einsetzmodul verschiedenartig ausgebildet. Dadurch kann der aus der Gehäuseschale hergestellte elektrische Verteiler beispielsweise verschiedene Steckerköpfe aufnehmen. Insbesondere ist zumindest das erste Einsetzmodul zur Aufnahme eines Steckerkopfes ausgelegt.

Vorteilhaft weist das erste Einsetzmodul eine kleinere Anzahl an Durchdringungsöffnungen auf als das zweite Einsetzmodul. Dadurch kann das erste Einsetzmodul beispielsweise zur Aufnahme eines vierpoligen Steckerkopfes ausgelegt und das zweite Einsetzmodul zur Aufnahme eines sechspoligen Steckerkopfes ausgelegt sein. Dadurch ist die Gehäuseschale flexibel an verschiedene Einsatzzwecke anpassbar.

Zweckmäßig weist das erste Einsetzmodul eine erste Aufnahmeöffnung zur Aufnahme eines ersten Steckerkopfes auf. Der erste Steckerkopf ist in eine Steckrichtung in die erste Aufnahmeöffnung steckbar. Die erste Aufnahmeöffnung weist einen senkrecht zur Steckrichtung gemessene erste Mindestquerschnittsfläche auf. Insbesondere weist das zweite Einsetzmodul eine zweite Aufnahmeöffnung zur Aufnahme eines zweiten Steckerkopfes auf. Der zweite Steckerkopf ist in eine Steckrichtung in die zweite Aufnahmeöffnung steckbar. Die zweite Aufnahmeöffnung weist eine senkrecht zur Steckrichtung gemessene zweiten Mindestquerschnittsfläche auf. Zweckmäßig ist die erste Mindestquerschnittsfläche kleiner als die zweite Mindestquerschnittsfläche. Dadurch können das erste Einsetzmodul und das zweite Einsetzmodul Steckerköpfe mit unterschiedlich großer Querschnittsfläche aufnehmen. Dadurch kann die Gehäuseschale durch Verwendung des jeweils passenden Einsetzmoduls an verschiedene Gegebenheiten einfach, schnell und flexibel angepasst werden. Da der Grundkörper jeweils unverändert bleibt, kann bei der Isolierung der Leiterplatte und der darauf angeordneten elektrischen Bauelemente mittels einer Spritzgussmasse aus thermoplastischem Elastomer dasselbe Spritzgusswerkzeug verwendet werden. Dies spart Produktionskosten.

Vorteilhaft sind die mehreren Einsetzmodule mittels einer Presspassung mit dem Grundkörper der Gehäuseschale verbindbar. Auf diese Weise kann die Gehäuseschale auf einfache Weise mit den benötigten Einsetzmodulen bestückt werden.

Zweckmäßig weist der Grundkörper mehrere Module zur Aufnahme der mehreren Einsetzmodule auf. Die mehreren Modulöffnungen sind als Durchdringungsöffnungen in dem Grundkörper ausgebildet. Die mehreren Modulöffnungen weisen zumindest eine erste Modulöffnung und eine zweite Modulöffnung auf. Insbesondere füllen die in die mehreren Modulöffnungen eingesetzten Einsetzmodule die mehreren Modulöffnungen vollständig aus. Zweckmäßig weisen zumindest die erste Modulöffnung und die zweite Modulöffnung Öffnungskonturen mit gleicher Form auf. Dadurch können in die erste Modulöffnung und in die zweite Modulöffnung flexibel die gewünschten Einsetzmodule eingesetzt werden. Beispielsweise können sowohl in die erste Modulöffnung als auch in die zweite Modulöffnung ein gleiches Einsetzmodul eingesetzt werden Es ist aber auch möglich, verschiedene Einsetzmodule in die erste Modulöffnung und die zweite Modulöffnung einzusetzen. Insbesondere korrespondieren die Außenkonturen des ersten Einsetzmoduls und des zweiten Einsetzmoduls mit der Öffnungskontur der ersten Modulöffnung und der Öffnungskontur der zweiten Modulöffnung. Die Außenkonturen der Einsetzmodule sind im in die Modulöffnungen eingesetzten Zustand der Einsetzmodule in eine Einsetzrichtung des jeweiligen Einsetzmoduls gesehen.

Vorteilhaft sind die mehreren Einsetzmodule derart in die mehreren Modulöffnungen einsetzbar, dass dadurch die von Durchgangsöffnungen freie Gehäuseaußenwand gebildet ist. Dadurch kann die Gehäuseschale sowohl flexibel für verschiedene Vergussmassentypen als auch zur Herstellung von elektrischen Verteilern mit hinsichtlich der Kontaktierung unterschiedlichen Anforderungen flexibel eingesetzt werden. Insbesondere sind die mehreren Einsetzmodule derart mit dem Grundkörper der Gehäuseschale verbindbar, dass die dabei gebildete Gehäuseaußenwand beim Ausgießen von Gießharz in die Gehäuseschale für das Gießharz dicht ist. Dadurch kann die Gehäuseschale sowohl in einem Kunststoffspritzgussverfahren mit einer Spritzgussmasse aus thermoplastischem Elastomer als auch beim Vergussverfahren mit einer Vergussmasse aus Gießharz verwendet werden.

Zweckmäßig ist zumindest zwischen dem in die erste Modulöffnung eingesetzten ersten Einsetzmodul und dem Grundkörper der Gehäuseschale eine Labyrinthdichtung ausgebildet. Insbesondere ist die Labyrinthdichtung am Rand der ersten Modulöffnung ausgebildet. Dadurch ist auf einfache Weise sichergestellt, dass kein Gießharz aus dem Inneren der Gehäuseschale durch die Gehäusewand hindurch austreten kann.

In vorteilhafter Weiterbildung der Erfindung umfasst ein elektrischer Verteiler eine erfindungsgemäße Gehäuseschale. Zweckmäßig umfasst der elektrische Verteiler eine Leiterplatte. Insbesondere trägt die Leiterplatte passive und/oder aktive elektrische Bauelemente. Die Leiterplatte ist vorteilhaft innerhalb der Gehäuseschale angeordnet. Die Gehäuseschale ist insbesondere mit einem Füllmaterial aus einer Spritzgussmasse aus thermoplastischem Elastomer verfüllt. Die Spritzgussmasse ist insbesondere in die Gehäuseschale gespritzt. Zweckmäßig umschließt die Spritzgussmasse die Leiterplatte mit den elektrischen Bauelementen vollständig. Insbesondere verbindet die Spritzgussmasse die Leiterplatte mechanisch mit der Gehäuseschale. Vorteilhaft ist die Spritzgussmasse vollständig innerhalb der bis auf die Durchdringungsöffnungen für die Stecckontakte von Durchgangsöffnungen freien Gehäuseaußenwand der Gehäuseschale angeordnet. Dadurch ist basierend auf der Gehäuseschale auf einfache Weise ein elektrischer Verteiler zur Verfügung gestellt.

Das erfindungsgemäße Kunststoffspritzgussverfahren zur Herstellung eines elektrischen Verteilers umfasst eine Gehäuseschale aus einem Kunststoffmaterial. Die Gehäuseschale weist eine Gehäuseaußenwand auf. In der Gehäuseaußenwand sind Durchdringungsöffnungen für Steckkontakte vorgesehen. Durch jede Durchdringungsöffnung ist ein Steckkontakt gesteckt. Die Durchdringungsöffnungen sind durch die Steckkontakte ausgefüllt. Das Kunststoffspritzgussverfahren umfasst eine Spritzgussmasse aus thermoplastischem Elastomer und eine mit passiven und/oder aktiven elektrischen Bauelementen bestückte Leiterplatte. Das Kunststoffspritzgussverfahren zur Herstellung eines elektrischen Verteilers umfasst folgende Verfahrensschritte:
- Anordnen der mit den elektrischen Bauelementen bestückten Leiterplatte in der Gehäuseschale,
- Anordnen der Gehäuseschale in einer Kavität eines Spritzgusswerkzeugs einer Spritzgießmaschine,
- Verflüssigen des Granulats als Rohmaterial des thermoplastischen Elastomers zu einer Schmelze durch Erhitzen des Granulats in einem Heizbereich eines Plastifizierzylinders der Spritzgießmaschine auf eine Heiztemperatur von mindestens 170°C,
- Fördern der Schmelze zu einer geschlossenen Düse des Plastifizierzylinders,
- Aufbauen eines Einspritzdrucks von höchstens 500 bar in der Schmelze,
- Öffnen der Düse und Einspritzen der Schmelze in die Kavität, so dass die Leiterplatte einschließlich der elektrischen Bauelemente mit der Spritzgussmasse umspritzt wird, und die Gehäuseschale mit der Schmelze verfüllt wird und
- Erstarren der Schmelze zur formstabilen Spritzgussmasse.

Erfindungsgemäß ist die Gehäuseaußenwand der Gehäuseschale, in die die Schmelze eingespritzt wird, mit Ausnahme der Durchdringungsöffnungen für die Steckkontakte vollständig frei von Durchgangsöffnungen. Insbesondere ist die Gehäuseaußenwand mit Ausnahme der Durchdringungsöffnungen vollständig geschlossen. Insbesondere weist die Gehäuseaußenwand mit Ausnahme der Durchdringungsöffnungen für die Stecckontakte keinerlei Öffnungen auf, durch die eine Vergussmasse aus Harz, insbesondere aus Vergießharz, aus dem Innenraum der Gehäuseschale austreten könnte. Zweckmäßig wird ein Einspritzdruck von mindestens 100 bar, insbesondere von mindestens 200 bar, insbesondere von mindestens 300 bar aufgebaut.

Ein Ausführungsbeispiel der Erfindung wird im Folgenden anhand der Zeichnung erläutert. Es zeigen:
- Fig. 1: eine perspektivische Darstellung einer Gehäuseschale,
- Fig. 2: eine perspektivische Darstellung von Einsetzmodulen der Gehäuseschale nach Fig. 1,
- Fig. 3: eine Draufsicht auf die Unterseite der Gehäuseschale aus Fig. 1,
- Fig. 4: eine Draufsicht auf die Oberseite der Gehäuseschale aus Fig. 1,
- Fig. 5: einen Schnitt entlang der in Fig. 4 eingezeichneten Schnittebene V-V,
- Fig. 6: eine schematische, beispielhafte Schnittdarstellung eines elektrischen Verteilers mit einer Gehäuseschale und
- Fig. 7: eine schematische Schnittdarstellung einer Spritzgießmaschine zur Herstellung des elektrischen Verteilers aus einer Gehäuseschale.

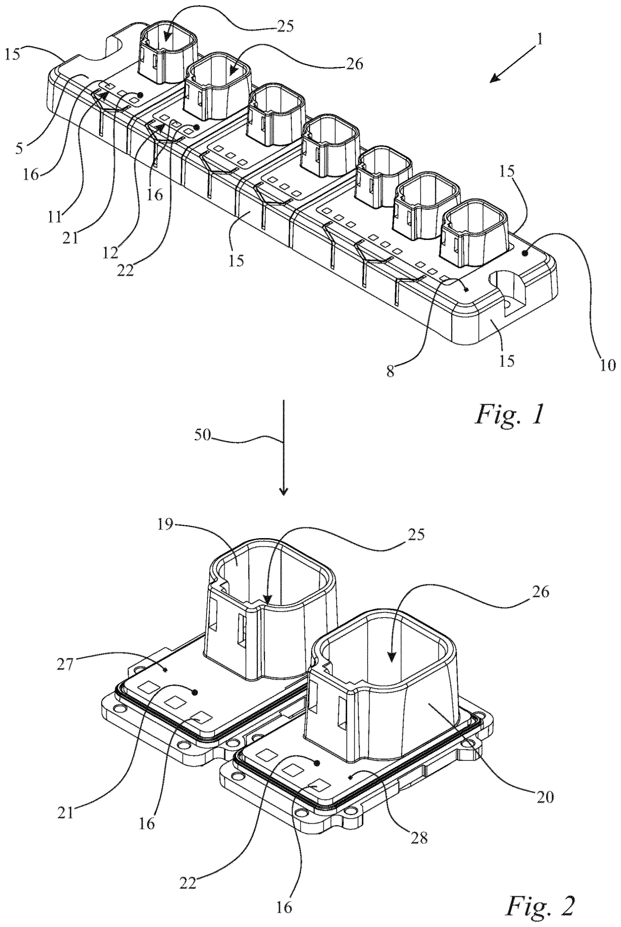

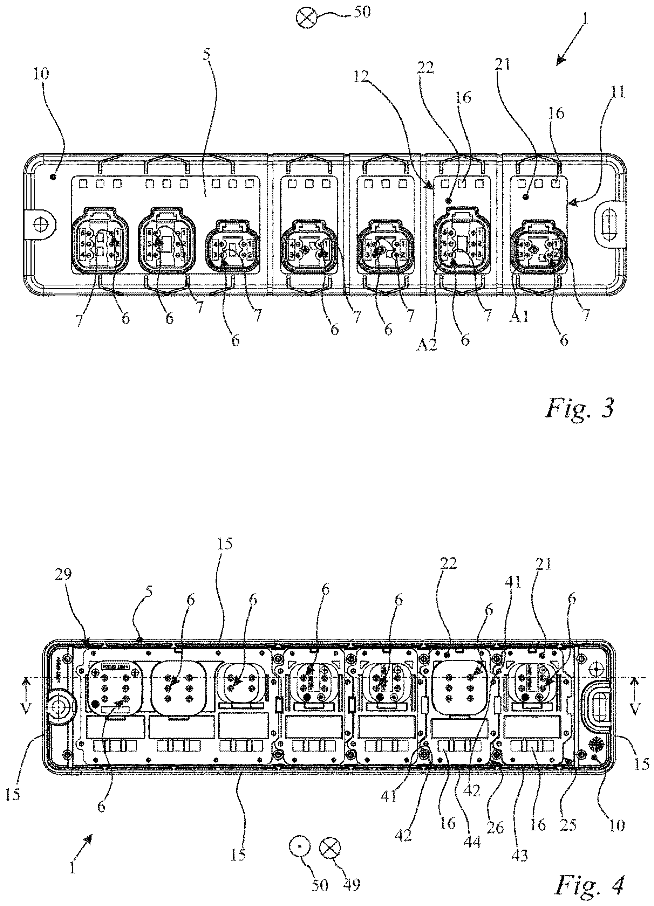

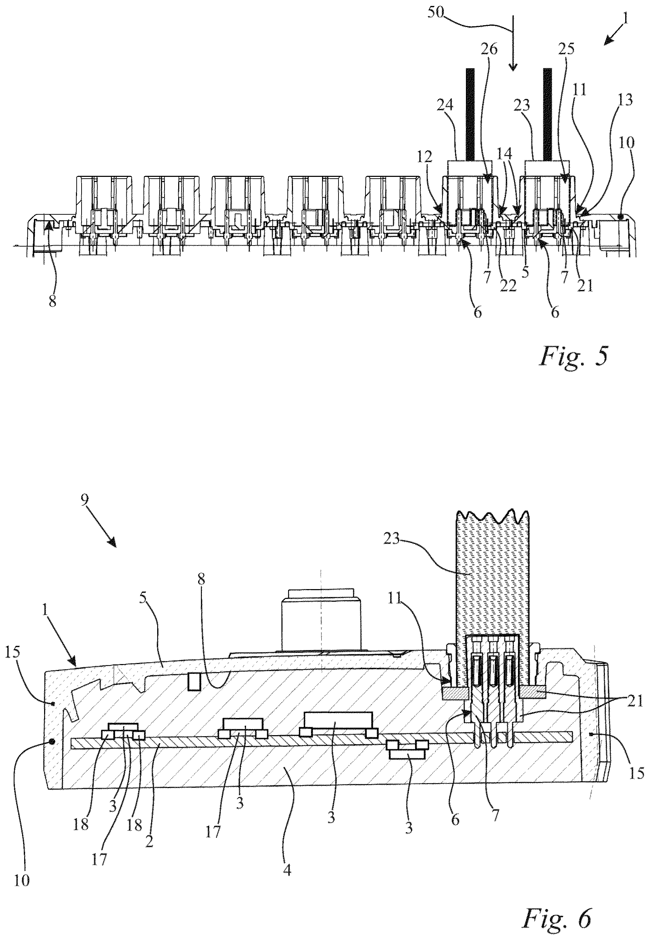

Fig. 1 zeigt eine Gehäuseschale 1. Die Gehäuseschale 1 ist aus Kunststoff. Wie die Zusammenschau der Fig. 1, 3 und 4 zeigt, ist die Gehäuseschale 1 wannenförmig. Die Gehäuseschale 1 umfasst vier Seitenelemente 15 und ein Bodenelement 8. Im Ausführungsbeispiel sind benachbarte Seitenelemente 15 orthogonal zueinander angeordnet. Insbesondere stehen alle Seitenelemente 15 rechtwinklig zum Bodenelement 8, so dass die Gehäuseschale 1 ihre Wannenform erhält. Im Ausführungsbeispiel sind die vier Seitenelemente 15 mit dem Bodenelement 8 derart verbunden, dass die wannenförmige Gehäuseschale 1 ein etwa quaderförmiges Innenvolumen begrenzt. Dem Bodenelement 8 gegenüberliegend ist eine in Fig. 4 dargestellte Füllöffnung 29 der Gehäuseschale 1 angeordnet. Die Füllöffnung 29 ist von den vier Seitenelementen 15 begrenzt. Durch die Füllöffnung 29 kann ein Füllmaterial 4 (Fig. 6) in die Gehäuseschale 1 gefüllt werden.

Die Gehäuseschale 1 ist dafür ausgelegt, dass das Füllmaterial 4 aus einer Spritzgussmasse aus thermoplastischem Elastomer mit einer Temperatur von mindestens 170°C, insbesondere von mindestens 200°C, vorteilhaft von mindestens 240°C, und mit einem Druck von mindestens 100 bar, insbesondere von mindestens 200 bar, vorteilhaft von mindestens 300 bar, beschädigungslos in die Gehäuseschale einspritzbar ist. Insbesondere beträgt der Einspritzdruck höchstens 500 bar. Hierbei verbindet sich die Spritzgussmasse des Füllmaterials 4 fest mit der Gehäuseschale 1. Die Gehäuseschale 1 ist so ausgelegt, dass sie hierbei formstabil bleibt. Die Gehäuseschale 1 umfasst eine Gehäuseaußenwand 5. Im Ausführungsbeispiel ist die Gehäuseaußenwand 5 aus einem harten, lichtundurchlässigen Material. Die Gehäuseschale 1, insbesondere die Gehäuseaußenwand 5, ist aus faserverstärktem Polyester. Insbesondere besteht das Material der Gehäuseschale 1, insbesondere der Gehäuseaußenwand 5, aus glasfaserverstärktem oder aus kohlefaserverstärktem Polyester. Bevorzugt beträgt der Faservolumenanteil mindestens 10%, insbesondere mindestens 20%. Vorteilhaft beträgt der Faservolumenanteil höchstens 50%, insbesondere höchstens 40%. Insbesondere besteht das Material der Gehäuseschale 1, insbesondere der Gehäuseaußenwand 5, aus einem faserverstärkten Gemisch aus zwei oder mehreren Polymeren, insbesondere aus einem Gemisch aus Polycarbonat (PC) und Polybutylenterephthalat (PBT). Im Ausführungsbeispiel ist das Material der Gehäuseschale 1, insbesondere der Gehäuseaußenwand 5, 30% glasfaserverstärktes Polycarbonat/Polybutylenterephthalat (PC/PBT) Harz. Dieses Material weist eine reduzierte Schrumpfung auf. Insbesondere besitzt das Material eine spritzgießbare Qualität. Zweckmäßig ist das Material bromiert. Insbesondere ist das Material flammhemmend. Vorteilhaft besitzt das Material der Gehäuseschale 1, insbesondere der Gehäuseaußenwand 5, eine Schmelztemperatur von mindestens 230°C, insbesondere von mindestens 240°C.

Insbesondere besitzt das Material der Gehäuseschale 1, insbesondere der Gehäuseaußenwand 5, eine Vicat-Erweichungstemperatur, Rate A/50, von mindestens 200°C. Vorteilhaft besitzt das Material der Gehäuseschale 1, insbesondere der Gehäuseaußenwand 5, eine Vicat-Erweichungstemperatur, Rate B/50, von mindestens 150°C. Dadurch ist während des Einspritzens des Füllmaterials aus einem thermoplastischen Elastomer mit einer Temperatur von mindestens 170°C und einem Druck von mindestens 100 bar in die Gehäuseschale 1 eine ausreichende Formstabilität, insbesondere eine ausreichende Dimensionstreue und/oder Maßhaltigkeit, der Gehäuseschale 1 gegeben.

Wie in den Fig. 3 und 4 dargestellt, weist die Gehäuseaußenwand 5 Durchdringungsöffnungen 6 für Steckkontakte 7 auf. Mit Ausnahme der Durchdringungsöffnungen 6 für die Steckkontakte 7 ist die Gehäuseaußenwand 5 der Gehäuseschale 1 frei von Durchgangsöffnungen. Die Gehäuseaußenwand 5, insbesondere das Bodenelement 8 der Gehäuseaußenwand 5, ist bis auf die Durchdringungsöffnungen 6 für Steckkontakte 7 vollständig geschlossen. Insbesondere ist die Gehäuseschale 1 mit Ausnahme der Durchdringungsöffnungen 6 für die Steckkontakte 7 dicht für eine Vergussmasse aus Harz, insbesondere aus Gießharz. Das Gießharz kann beispielsweise ein Epoxidharz oder ein Polyurethanharz sein. Das Gießharz kann insbesondere bei einer Temperatur von weniger als 60°C, insbesondere von weniger als 50°C, bevorzugt von weniger als 40°C vergossen werden.

Im Ausführungsbeispiel sind die Durchdringungsöffnungen 6 für die Steckkontakte 7 im Bodenelement 8 der Gehäuseaußenwand 5 ausgebildet.

Die Gehäuseschale 1 weist die Steckkontakte 7 auf. Die Steckkontakte 7 bestehen aus Metall. Durch jede Durchdringungsöffnung 6 ist ein Steckkontakt 7 gesteckt, wie beispielsweise in Fig. 3 dargestellt. Die Durchdringungsöffnungen 6 sind durch die Stecckontakte 7 vollständig ausgefüllt. Insbesondere verhindert der in die Durchdringungsöffnung 6 gesteckte Steckkontakt 7 einen Durchfluss von Vergussmasse aus Harz durch die Durchdringungsöffnung 6.

Die Gehäuseschale 1 ist dazu ausgelegt, mit einem Gießharz vergossen zu werden.

Wie in Fig. 6 dargestellt, dient die Gehäuseschale 1 zur Aufnahme einer Leiterplatte 2. Auf der Leiterplatte 2 sind elektrische Bauelemente 3 angeordnet. Bei den elektrischen Bauelementen 3 kann es sich um passive und/oder aktive elektrische Bauelemente handeln. In Fig. 6 ist ebenfalls das Füllmaterial 4 dargestellt. Das Füllmaterial besteht aus einer Spritzgussmasse aus thermoplastischem Elastomer. Insbesondere ist die Spritzgussmasse lichtdurchlässig. Im Ausführungsbeispiel ist als thermoplastisches Elastomer Polyurethan verwendet. Das thermoplastische Elastomer erreicht eine Shore-Härte von 85 Shore A. Die Spritzgussmasse ist in die Gehäuseschale 1 gespritzt und schließt mit den Seitenelementen 15 bündig ab. Die Spritzgussmasse füllt insbesondere das Innenvolumen der Gehäuseschale 1 vollständig aus. Aufgrund der Auslegung der Gehäuseschale 1 kann in die Gehäuseschale 1 sowohl ein Füllmaterial aus Gießharz in die Gehäuseschale 1 vergossen werden, als auch ein Füllmaterial aus einer Spritzgussmasse aus thermoplastischem Elastomer in die Gehäuseschale 1 gespritzt werden. Je nach Stückzahl von herzustellenden elektrischen Verteilern 9 ist ein Vergussverfahren oder ein Kunststoffspritzgussverfahren kostengünstiger. Die erfindungsgemäße Gehäuseschale 1 kann für beide Verfahren flexibel eingesetzt werden.

Insbesondere sind die elektrischen Bauelemente 3 SMD-Bauteile. Im Ausführungsbeispiel umfassen die elektrischen Bauelemente 3 sowohl aktive als auch passive elektrische Bauelemente. Die aktiven elektrischen Bauelemente umfassen ein Lichtelement, beispielsweise eine LED, einen Quarz, einen Prozessor und dergleichen. Das passive elektrische Bauelement ist beispielsweise ein Widerstand. Sämtliche elektrischen Bauelemente 3 sind elektrisch mit der Leiterplatte 2 verbunden. Die Steckkontakte 7 sind ebenfalls elektrisch mit der Leiterplatte 2 verbunden. Im Ausführungsbeispiel ist jeder der Steckkontakte 7 durch die Gehäuseaußenwand 5 der Gehäuseschale 1, nämlich durch das Bodenelement 8, geführt. Wie in Fig. 5 dargestellt, kann an jeden der Stecckontakte 7 ein Steckkopf 23, 24 mit einem Kabel angeschlossen werden, um den elektrischen Verteiler 9 mit einem weiteren, nicht gezeigten elektrischen Gerät zu verbinden. In Fig. 5 sind beispielshaft ein erster Steckkopf 23 und ein zweiter Steckkopf 24 gestrichelt eingezeichnet. Im Ausführungsbeispiel greifen die Steckkontakte 7 in den Steckerkopf 23, 24 ein.

Wie in Fig. 6 dargestellt, umschließt die Spritzgussmasse des Füllmaterials 4 die Leiterplatte 2 vollständig. Die Spritzgussmasse schließt bündig mit den Enden der Seitenelemente 15 ab. Die Spritzgussmasse ist mit den Innenseiten der Seitenelemente 15 und mit der Innenseite des Bodenelements 8 fest verbunden. Dadurch verbindet die Spritzgussmasse die Leiterplatte 2 mechanisch mit der Gehäuseschale 1. Ein Eintreten von Schmutz und/oder Wasser in den Verteiler 9 ist dadurch wirkungsvoll unterbunden, so dass der Verteiler 9 den geforderten Dichtheitsgrad der Schutzklasse IP67 erfüllt.

Obwohl bei dem Spritzgussverfahren hohe Temperaturen beim Einspritzen des Füllmaterials 4 in die Gehäuseschale 1 entstehen, werden die auf der Leiterplatte 2 angeordneten elektrischen Bauelemente 3 bei der Herstellung nicht beschädigt, da die elektrischen Bauteile 3 nur über eine sehr kurze Zeit sehr hohen thermischen Belastungen ausgesetzt sind und in dieser Zeit keinen thermischen Schaden nehmen. Im hier beschriebenen Spritzgussverfahren sind die Drücke, die beim Einspritzen des Füllmaterials 4 in die Gehäuseschale 1 entstehen und auf die auf der Leiterplatte 2 angeordneten elektrischen Bauelemente 3 wirken, verglichen mit konventionellen Spritzgussverfahren gering. Dadurch entstehen bei der Herstellung keine mechanischen Schäden an den elektrischen Bauteilen 3. Damit kann das Füllmaterial 4 in die Gehäuseschale 1 eingespritzt werden, ohne dass die elektrischen Bauelemente 3 beschädigt werden.

Im Ausführungsbeispiel leitet die lichtdurchlässige Spritzgussmasse des Füllmaterials 4 Licht, welches von einem als Lichtelement ausgebildeten elektrischen Bauelement 3 ausgestrahlt wird, zu einem lichtdurchlässigen Element 16 (Fig. 1). Das lichtdurchlässige Element 16 ist Bestandteil der Gehäuseaußenwand 5. Zusätzliche Vorkehrungen, beispielsweise Dichtungstüllen, die einen Lichtkanal vom als Lichtelement ausgebildeten elektrischen Bauelement 3 zum lichtdurchlässigen Element 16 bilden, sind nicht erforderlich, da die lichtdurchlässige Spritzgussmasse als Lichtleiter dient.

Zwischen den elektrischen Bauelementen 3 und der Leiterplatte 2 ist jeweils ein Zwischenraum 17 gebildet. Der Zwischenraum 17 ist im Ausführungsbeispiel vollständig mit Spritzgussmasse gefüllt. Dadurch sind die elektrischen Bauelemente 32 bis auf die direkte Befestigung über elektrische Anschlüsse 18 an der Leiterplatte 2 vollständig von der Spritzgussmasse umgeben. Dadurch ist gewährleistet, dass die elektronischen Bauelemente 3 mechanisch fest mit der Leiterplatte 2 verbunden sind. Außerdem sind die elektronischen Bauelemente 3 wasser- und staubgeschützt im Verteiler 9 angeordnet, da sie vollständig von der Spritzgussmasse umgeben sind.

Wie in Fig. 1 dargestellt, umfasst die Gehäuseschale 1 einen Grundkörper 10. Der Grundkörper 10 besteht aus Kunststoff. Der Grundkörper 10 ist im Ausführungsbeispiel ein Spritzgussteil. Der Grundkörper 10 ist in einem Spritzgussverfahren hergestellt. Der Grundkörper 10 umfasst die vier Seitenelemente 15. Ein Teil des Bodenelements 8 ist ebenfalls durch den Grundkörper 10 gebildet. Der Grundkörper 10 ist aus einem harten Kunststoff. Der Grundkörper 10 ist insbesondere lichtundurchlässig. Der Grundkörper 10 ist dafür ausgelegt, dass er bei einem Kontakt mit einem Füllmaterial aus Spritzgussmasse aus einem thermoplastischen Elastomer mit einer Temperatur von mindestens 170°, insbesondere von mindestens 200°, vorteilhaft von mindestens 240° und einem Druck von mindestens 100 bar, insbesondere von mindestens 200 bar, vorteilhaft von mindestens 400 bar, unbeschädigt und formstabil bleibt. Der Grundkörper 10 bildet einen Teil der Gehäuseaußenwand 5.

Wie in Fig. 1 dargestellt, umfasst der Grundkörper 10 mehrere Modulöffnungen 11, 12. Die mehreren Modulöffnungen 11, 12 dienen zur Aufnahme von mehreren Einsetzmodulen 21, 22. Die mehreren Einsetzmodule 21, 22 sind Bestandteil der Gehäuseschale 1. Die mehreren Einsetzmodule 21, 22 sind getrennt von dem Grundkörper 10 ausgebildet. Die mehreren Modulöffnungen 11, 12 durchdringen den Grundkörper 10 vollständig. Die mehreren Modulöffnungen 11, 12 durchdringen den Grundkörper 10 der Gehäuseschale 1 vollständig. Die mehreren Einsetzmodule 21, 22 sind derart in die mehreren Modulöffnungen 11, 12 einsetzbar, dass dadurch die von Durchgangsöffnungen freie Gehäuseaußenwand 5 gebildet ist. Die mehreren Einsetzmodule 21, 22 sind derart mit dem Grundkörper 10 der Gehäuseschale 1 verbindbar, dass die dabei gebildete Gehäuseaußenwand 5 beim Ausgießen von Gießharz in die Gehäuseschale 1 für das Gießharz dicht ist. Die Durchdringungsöffnungen 6 für die Steckkontakte 7 sind in den mehreren Einsetzmodulen 21, 22 ausgebildet. Im Ausführungsbeispiel sind alle Durchdringungsöffnungen 6 für die Steckkontakte 7 in den mehreren Einsetzmodulen 21, 22 ausgebildet. Insbesondere sind in dem Grundkörper 10 keine Durchdringungsöffnungen 6 für die Steckkontakte 7 ausgebildet.

Die mehreren Einsetzmodule 21, 22 umfassen mindestens ein erstes Einsetzmodul 21 und ein zweites Einsetzmodul 22. Die mehreren Modulöffnungen 11, 12 umfassen mindestens eine erste Modulöffnung 11 und eine zweite Modulöffnung 12. Zumindest die erste Modulöffnung 11 und die zweite Modulöffnung 12 weisen Öffnungskonturen mit gleicher Form auf. Zumindest das erste Einsetzmodul 21 und das zweite Einsetzmodul 22 besitzen jeweils ein Grundelement 27, 28. Das Grundelement 27, 28 korrespondiert mit der Öffnungskontur der Modulöffnung 11, 12. Die Grundelemente 27 und 28 bilden zusammen mit dem Grundkörper 10 die Gehäuseaußenwand 5. Das erste Einsetzmodul 21 besitzt im eingebauten Zustand des ersten Einsetzmoduls 21 in Einsetzrichtung 49 des ersten Einsetzmoduls 27 gesehen eine erste Außenkontur 43, wie in Fig. 4 mit gestrichelter Linie dargestellt. Die erste Außenkontur 43 korrespondiert mit der Öffnungskontur der ersten Modulöffnung 11. Die erste Außenkontur 43 überlappt die Öffnungskontur der ersten Modulöffnung 11 allseitig. Die erste Außenkontur 43 ist größer als die Öffnungskontur der ersten Modulöffnung 11. Das zweite Einsetzmodul 22 besitzt im eingebauten Zustand des zweiten Einsetzmoduls 22 in Einsetzrichtung 49 des zweiten Einsetzmoduls 28 gesehen eine zweite Außenkontur 44, wie in Fig. 4 mit gestrichelter Linie dargestellt. Die zweite Außenkontur 44 korrespondiert mit der Öffnungskontur der zweiten Modulöffnung 12. Die zweite Außenkontur 44 überlappt die Öffnungskontur der zweiten Modulöffnung 12 allseitig. Die zweite Außenkontur 44 ist größer als die Öffnungskontur der zweiten Modulöffnung 12. Die erste Außenkontur 43 und die zweite Außenkontur 44 sind in Form und Größe identisch. Die Einsetzrichtung 49 ist sowohl für das erste Einsetzmodul 21 als auch für das zweite Einsetzmodul 22, im Ausführungsbeispiel für alle Einsetzmodule, gleich. Die Einsetzrichtung 49 verläuft entgegengesetzt zu Einsteckrichtung 50.

Die Durchdringungsöffnungen 6 sind ausschließlich in den Grundelementen 27, 28 angeordnet. Die Grundelemente 27, 28 weisen die lichtdurchlässigen Elemente 16 auf.

Zumindest das erste Einsetzmodul 21 und das zweite Einsetzmodul 22 sind verschiedenartig ausgebildet. Das erste Einsetzmodul 21 weist eine kleinere Anzahl an Durchdringungsöffnungen 6 auf als das zweite Einsetzmodul 22. Im Ausführungsbeispiel weist das erste Einsetzmodul vier Durchdringungsöffnungen 6 und das zweite Einsetzmodul sechs Durchdringungsöffnungen 6 auf.

Wie in Fig. 5 dargestellt, ist das Einsetzmodul 21, 22 zur Aufnahme eines Steckerkopfes 23, 24 ausgelegt. Das erste Einsetzmodul 21 weist eine erste Aufnahmeöffnung 25 zur Aufnahme des ersten Steckerkopfes 23 auf. Das zweite Einsetzmodul 22 weist eine zweite Aufnahmeöffnung 26 zur Aufnahme des zweiten Steckerkopfes 24 auf. Wie in Fig. 2 dargestellt, ist die erste Aufnahmeöffnung 25 von einer umlaufenden ersten Aufnahmewand 19 begrenzt. Die erste Aufnahmewand 19 ist an das erste Grundelement 27 des ersten Einsetzmoduls 21 angeformt. Die erste Aufnahmewand 19 läuft um die Einsteckrichtung 50 um. Die zweite Aufnahmeöffnung 26 ist von einer zweiten Aufnahmewand 20 begrenzt. Die zweite Aufnahmewand 20 ist an das zweite Grundelement 28 des zweiten Einsetzmoduls 22 angeformt. Die zweite Aufnahmewand 20 läuft um die Einsteckrichtung 50 um. Wie in Fig. 3 dargestellt, besitzt die erste Aufnahmeöffnung 27 eine erste Mindestquerschnittsfläche A1. Die zweite Aufnahmeöffnung 28 besitzt eine zweite Mindestquerschnittsfläche A2. Die Mindestquerschnittsflächen A1, A2 sind jeweils senkrecht zur Einsteckrichtung 50 gemessen. Die erste Mindestquerschnittsfläche A1 ist kleiner als die zweite Mindestquerschnittsfläche A2.

Die mehreren Einsetzmodule 21, 22 sind mittels einer Presspassung mit dem Grundkörper 10 der Gehäuseschale 1 verbindbar. Wie in Fig. 4 dargestellt, besitzt der Grundkörper 10 Presspassstifte 42. Die Presspassstifte 42 erstrecken sich im eingebauten Zustand der Einsetzmodule 21, 22 in Einsteckrichtung 50. Die Einsteckrichtung 50 ist die Richtung, in die ein Steckerkopf 23, 24 in die Aufnahmeöffnung 25, 26 des Einsetzmoduls 21, 22 eingeführt werden muss, um mit den Steckkontakten 7 verbunden zu werden. Am Einsetzmodul 21, 22 sind Presspassöffnungen 41 ausgebildet. Die Presspassöffnungen 41 korrespondieren mit den Presspassstiften 42. Beim Zusammenbau der Gehäuseschale 1 wird das Einsetzmodul 21, 22 in Richtung entgegen der Einsteckrichtung 50 mit seinen Presspassöffnungen 41 auf die Presspassstifte 42 gesteckt. Anschließend wird das Einsetzmodul 21, 22 gegen den Grundkörper 10 in die Modulöffnung 11, 12 gepresst. Hierbei wird das Einsetzmodul 21, 22 fest mit dem Grundkörper 10 verbunden. Zu diesem Zweck sind die Presspassstifte 42 konisch ausgebildet.

Zumindest zwischen dem in die erste Modulöffnung 11 eingesetzten ersten Einsetzmodul 21 und dem Grundkörper 10 der Gehäuseschale 1 ist eine in Fig. 5 dargestellte Labyrinthdichtung 14 ausgebildet. Im Ausführungsbeispiel ist auch zwischen dem in die zweite Modulöffnung 12 eingesetzten zweiten Einsetzmodul 22 und dem Grundkörper 10 der Gehäuseschale 1 eine Labyrinthdichtung 14 ausgebildet. Die Labyrinthdichtung 14 ist im Ausführungsbeispiel am Rand der Modulöffnung 11, 12 ausgebildet. Im Ausführungsbeispiel läuft die Labyrinthdichtung 14 in Einsteckrichtung 50 um die Modulöffnung 11, 12 um. Die Labyrinthdichtung 14 ist eine statische Dichtung. Die Labyrinthdichtung 14 wird auch als Totlaufdichtung bezeichnet. In einer Schnittebene senkrecht zum Rand der Modulöffnung 11, 12 weisen sowohl der Rand der Modulöffnung 11, 12 als auch der hierzu korrespondierende Rand des Einsetzmoduls 21, 22 eine labyrinthartige und/oder mäanderförmige Form auf. Insbesondere ist am Rand der Modulöffnung 11, 12 eine umlaufende Nut mit zwei Nutseitenwänden ausgebildet. Hierzu korrespondierend besitzt das Einsetzmodul 21, 22 eine Feder, die im zusammengebauten Zustand in die Nut eingreift. Die Feder läuft als Vorsprung um den Rand des Einsetzmoduls 21, 22 um. Nach dem Zusammenbau der Gehäuseschale 1 ist die Verbindung zwischen dem Einsetzmodul 21, 22 und dem Grundkörper 10 mit Ausnahme der Durchdringungsöffnungen 6 dicht gegenüber einer Vergussmasse aus Gießharz.

Wie in Fig. 6 dargestellt, ist die Leiterplatte 2 des elektrischen Verteilers 9 innerhalb der Gehäuseschale 1 angeordnet. Die Gehäuseschale 1 ist mit einem Füllmaterial 4 aus einer Spritzgussmasse aus thermoplastischem Elastomer verfüllt. Die Spritzgussmasse ist in die Gehäuseschale 1 gespritzt. Die Spritzgussmasse umschließt die Leiterplatte 2 mit den elektrischen Bauelementen 3 vollständig. Die Spritzgussmasse verbindet die Leiterplatte 2 mechanisch mit der Gehäuseschale 1. Die Spritzgussmasse ist vollständig innerhalb der bis auf die Durchdringungsöffnungen für die Steckkontakte von Durchgangsöffnungen freien Gehäuseaußenwand 5 der Gehäuseschale 1 angeordnet.

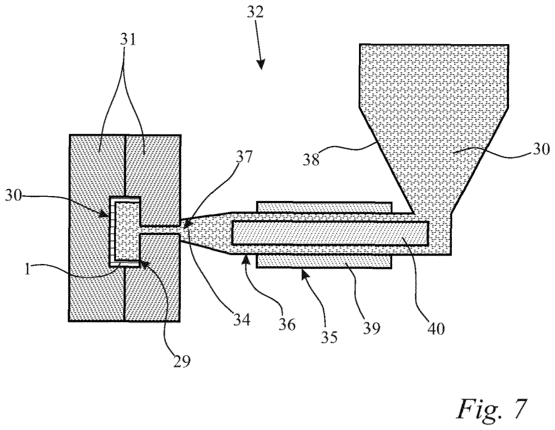

Fig. 7 zeigt eine Spritzgießmaschine 32. Mit der Spritzgießmaschine 32 wird aus der Gehäuseschale 1 der elektrische Verteiler 9 hergestellt. Die Spritzgießmaschine 32 umfasst einen Einfülltrichter 38, in welchem das Granulat 33 als Rohmaterial des thermoplastischen Elastomers eingefüllt wird. Die Spritzgießmaschine 32 umfasst ein Spritzgusswerkzeug 31 mit einer Kavität 30. Die Gehäuseschale 1 wird zusammen mit der in der Gehäuseschale 1 angeordneten Leiterplatte 2 in der Kavität 30 angeordnet. Die Spritzgießmaschine 32 umfasst einen Heizbereich 35 eines Plastifizierzylinders 36, in welchem das Granulat 33 verflüssigt wird. Hierzu sind im Heizbereich 35 Heizelemente 39 vorgesehen. Das Granulat 33 wird auf eine Heiztemperatur von mindestens 170°C, insbesondere von mindestens 200°C, insbesondere von mindestens 270°C erhitzt und zu einer Schmelze 34 verflüssigt. Damit wird das Granulat 33 auf eine Heiztemperatur erhitzt, die höher ist als die übliche Verarbeitungstemperatur eines thermoplastischen Elastomers, beispielsweise Polyurethan. Bei solch hohen Heiztemperaturen besteht die Gefahr, dass der Werkstoff zerstört wird. Dennoch wird in diesem Spritzgussverfahren das Granulat auf diese hohe Heiztemperatur erhitzt, da sich die hohe Heiztemperatur vorteilhaft auf das Spritzgießverfahren auswirkt, wie nachfolgend beschrieben wird. Die Gehäuseschale 1 ist entsprechend für solche hohen Temperaturen ausgelegt. Bei einem Spritzgussverfahren mit solchen hohen Temperaturen wird die Gehäuseschale 1 weder temperaturbedingt beschädigt noch verformt.

Die Spritzgießmaschine 32 umfasst eine Schnecke 40, die das Granulat 33 in den Heizbereich 35 fördert und die Schmelze 34 zu einer Düse 37 fördert. Die Düse 37 ist zunächst geschlossen. Durch die kontinuierliche Förderung der Schmelze 34 zur Düse 37 wird ein Einspritzdruck von höchstens 500 bar, insbesondere von höchstens 300 bar, insbesondere von höchstens 200 bar, in der Schmelze 36 aufgebaut. Der Einspritzdruck beträgt mindestens 100 bar, insbesondere mindestens 200 bar, insbesondere mindestens 300 bar. Nach Aufbau des gewünschten Einspritzdrucks wird die mit dem Spritzgusswerkzeug 31 verbundene Düse 37 geöffnet und die Schmelze 34 wird in die Kavität 30 eingespritzt. Hierbei wird die Schmelze 34 in die Gehäuseschale 1 eingespritzt und die Leiterplatte 2 wird von der Schmelze 34 umschlossen. Beim Einspritzen der Schmelze 34 in die Gehäuseschale 1 tritt die Schmelze 34 durch die Füllöffnung 29 in die Gehäuseschale 1 ein. Die Gehäuseschale 1 ist dafür ausgelegt, mindestens einem Druck von 100 bar, insbesondere von mindestens 200 bar, insbesondere von mindestens 300 bar standzuhalten. Hierbei wird die Gehäuseschale 1 weder beschädigt noch verformt. Dadurch, dass die Schmelze 34 vergleichsweise heiß und dadurch dünnflüssig ist, kann der Einspritzdruck vergleichsweise niedrig gewählt werden. Durch einen niedrigen Einspritzdruck ist die mechanische Belastung auf die elektrischen Bauelemente 3 beim Einspritzen der Schmelze 34 gering. Eine mechanische Beschädigung der elektrischen Bauelemente 3 aufgrund des Einspritzdrucks ist unterbunden.

Schließlich erstarrt die Schmelze 34 in der Gehäuseschale 1 zur formstabilen Spritzgussmasse. Hierbei nimmt das Spritzgusswerkzeug 31 einen Teil der Wärmeenergie der Schmelze 34 auf. Obwohl die zwischen Schmelze 34 und Spritzgusswerkzeug 31 angeordnete Gehäuseschale 1 wie ein thermischer Isolator wirkt und einen Wärmeabfluss beim Erstarren der Schmelze 34 in das Spritzgusswerkzeug 31 erschwert, nehmen bei diesem Herstellverfahren die elektrischen Bauelemente 3 keinen thermischen Schaden, da das Erstarren der Schmelze 34 zur formstabilen Spritzgussmasse höchstens 3 Minuten dauert. Damit ist die Zeitdauer, in der die elektrischen Bauteile 3 einer hohen Temperatur ausgesetzt sind, gering und ein thermischer Schaden kann trotz der vergleichsweise hohen Temperatur in der Schmelze 34 nicht entstehen.

Auch dadurch, dass die Gehäuseschale 1 eine Wannenform aufweist, kann auf der dem Bodenelement 8 abgewandten Seite des Verteilers 9 viel Wärme aus der Schmelze 34 in das Spritzgusswerkzeug 31 fließen. Damit kann gewährleistet werden, dass in der Zeit des Erstarrens der Schmelze 34 der Wärmeeintrag von der Schmelze 34 auf die elektrischen Bauelemente 3 gering ist und die elektrischen Bauelemente 3 keinen thermischen Schaden erleiden.

Beim Einspritzen der Schmelze 34 in die Gehäuseschale 2 und beim Umspritzen der Leiterplatte 2 tritt ein Teil der Schmelze 34 in den Zwischenraum 17 zwischen den elektrischen Bauelementen 3 und der Leiterplatte 2 ein. Durch die vergleichsweise hohe Temperatur der Schmelze 34 ist die Schmelze 34 dünnflüssig, so dass die Schmelze 34 ohne große mechanische Belastung auf die elektrischen Bauelemente 3 in den Zwischenraum 17 fließen kann. Eine mechanische Beschädigung der elektrischen Bauelemente 3, beispielsweise ein Abplatzen der Bauelemente von der Leiterplatte 2 beim Einspritzen, ist dadurch unterbunden. Dadurch, dass die Gehäuseaußenwand 5 der Gehäuseschale 1, in die die Schmelze 34 eingespritzt wird, mit Ausnahme der Durchdringungsöffnungen 6 für die Steckkontakte 7, vollständig frei von Durchgangsöffnungen ist, kann die im Spritzgussverfahren verwendete Gehäuseschale 1 problemlos auch zur Herstellung eines elektrischen Verteilers verwendet werden, bei dem anstatt des thermoplastischen Elastomers eine Vergussmasse aus Vergießharz zur Isolierung der elektrischen Bauelemente 3 verwendet wird. Aufgrund der geschlossenen Gestaltung der Gehäuseschale 1 ist ein unerwünschtes Heraustropfen der Vergussmasse aus Durchgangsöffnungen vermieden.

Die Durchdringungsöffnungen 6 sind bei Durchführung des Spritzgussverfahrens insbesondere durch Steckkontakte 7 verschlossen. Durch jede Durchgangsöffnung 6 ist ein Steckkontakt 7 gesteckt. Die Durchdringungsöffnungen 6 sind durch die Steckkontakte 7 vollständig ausgefüllt. Dadurch, dass die Gehäuseaußenwand 5 der Gehäuseschale 1 mit Ausnahme der Durchdringungsöffnungen 6 vollständig frei von Durchgangsöffnungen ist, kann die Gehäuseschale 1 flexibel nicht nur in dem beschriebenen Spritzgussverfahren mit einer Spritzgussmasse aus thermoplastischem Elastomer verwendet werden, sondern auch bei einem Vergussverfahren, bei dem als Vergussmasse ein Gießharz verwendet wird. Gießharz besitzt im verflüssigten Zustand eine geringe Viskosität und kann leicht aus Öffnungen einer Gehäuseaußenwand austreten. Dadurch, dass derartige Öffnungen bei der Gehäuseschale 1 entweder nicht vorhanden oder von Steckkontakten 7 ausgefüllt sind, kann die Gehäuseschale 1 auch in einem Gießharzvergussverfahren verwendet werden.

## Patentansprüche

1. Gehäuseschale zur Aufnahme eine Leiterplatte (2) mit passiven und/oder aktiven elektrischen Bauelementen (3) und zur Aufnahme von Füllmaterial (4) aus einer Spritzgussmasse aus thermoplastischem Elastomer, wobei die Gehäuseschale (1) aus einem Kunststoffmaterial besteht, wobei die Gehäuseschale (1) dafür ausgelegt ist, dass das Füllmaterial (4) aus Spritzgussmasse aus einem thermoplastischen Elastomer mit einer Temperatur von mindestens 170°C und mit einem Druck von mindestens 100 bar in die Gehäuseschale (1) beschädigungslos einspritzbar ist, so dass sich die Spritzgussmasse fest mit der Gehäuseschale (1) verbindet und die Gehäuseschale (1) formstabil bleibt, wobei die Gehäuseschale (1) eine Gehäuseaußenwand (5) aufweist, wobei in der Gehäuseaußenwand (5) Durchdringungsöffnungen (6) für Steckkontakte (7) vorgesehen sind,
**dadurch gekennzeichnet, dass** die Gehäuseaußenwand (5) der Gehäuseschale (1) mit Ausnahme der Durchdringungsöffnungen (6) für die Steckkontakte (7) frei von Durchgangsöffnungen ist.

2. Gehäuseschale nach Anspruch 1,
**dadurch gekennzeichnet, dass** die Gehäuseschale (1) wannenförmig ausgebildet ist, dass die Gehäuseaußenwand (5) ein Bodenelement (8) besitzt, das einen Boden der Gehäuseschale (1) bildet, dass die Durchdringungsöffnungen (6) für die Steckkontakte (7) im Bodenelement (8) ausgebildet sind.

3. Gehäuseschale nach Anspruch 1 oder 2,
**dadurch gekennzeichnet, dass** die Gehäuseschale (1) Steckkontakte (7) aufweist, dass durch jede Durchdringungsöffnung (6) ein Steckkontakt (7) gesteckt ist, wobei die Durchdringungsöffnungen (6) durch die Steckkontakte (7) ausgefüllt sind.

4. Gehäuseschale nach einem der Ansprüche 1 bis 3,
**dadurch gekennzeichnet, dass** die Gehäuseschale (1) dafür ausgelegt ist, mit einem Gießharz ausgegossen zu werden.

5. Gehäuseschale nach einem der Ansprüche 1 bis 4,
**dadurch gekennzeichnet, dass** die Gehäuseschale (1) einen Grundkörper (10) und mehrere Einsetzmodule (21, 22) umfasst, dass die mehreren Einsetzmodule (21, 22) mindestens ein erstes Einsetzmodul (21) und ein zweites Einsetzmodul (22) umfassen, dass die mehreren Einsetzmodule (21, 22) getrennt von dem Grundkörper (10) ausgebildet sind, und dass die Durchdringungsöffnungen (6), insbesondere alle Durchdringungsöffnungen (6), in den mehreren Einsetzmodulen (21, 22) ausgebildet sind.

6. Gehäuseschale nach Anspruch 5,
**dadurch gekennzeichnet, dass** zumindest das erste Einsetzmodul (21) und das zweite Einsetzmodul (22) verschiedenartig ausgebildet sind, und insbesondere dass zumindest das erste Einsetzmodul (21) zur Aufnahme eines Steckerkopfes (23, 24) ausgelegt ist.

7. Gehäuseschale nach Anspruch 5 oder 6,
**dadurch gekennzeichnet, dass** das erste Einsetzmodul (21) eine kleinere Anzahl an Durchdringungsöffnungen (6) aufweist als das zweite Einsetzmodul (22).

8. Gehäuseschale nach einem der Ansprüche 5 bis 7,
**dadurch gekennzeichnet, dass** das das erste Einsetzmodul (21) eine erste Aufnahmeöffnung (25) zur Aufnahme eines ersten Steckerkopfes (23) aufweist, dass die erste Aufnahmeöffnung (25) einen erste senkrecht zur Steckrichtung (50) des ersten Steckerkopfes (23) gemessene Mindestquerschnittsfläche (A1) aufweist, dass das zweite Einsetzmodul (22) eine zweiten Aufnahmeöffnung (26) zur Aufnahme eines zweiten Steckerkopfes (24) aufweist, dass die zweite Aufnahmeöffnung (26) eine senkrecht zur Steckrichtung (50) des zweiten Steckerkopfs (24) gemessene zweiten Mindestquerschnittsfläche (A2) aufweist, und dass die erste Mindestquerschnittsfläche (A1) kleiner als die zweite Mindestquerschnittsfläche (A2) ist.

9. Gehäuseschale nach einem der Ansprüche 5 bis 8,
**dadurch gekennzeichnet, dass** die mehreren Einsetzmodule (21, 22) mittels einer Presspassung mit dem Grundkörper (10) der Gehäuseschale (1) verbindbar sind.

10. Gehäuseschale nach einem der Ansprüche 5 bis 9,
**dadurch gekennzeichnet, dass** der Grundkörper (10) mehrere Modul Öffnungen (11, 12) zur Aufnahme der mehreren Einsetzmodule (21, 22) aufweist, dass die mehreren Modulöffnungen (11, 12) als Durchdringungsöffnungen in dem Grundkörper (10) ausgebildet sind, dass die mehreren Modulöffnungen (21, 22) zumindest eine erste Modulöffnung (11) und eine zweite Modulöffnung (12) aufweisen.

11. Gehäuseschale nach Anspruch 10,
**dadurch gekennzeichnet, dass** zumindest die erste Modulöffnung (11) und die zweite Modulöffnung (12) Öffnungskonturen mit gleicher Form aufweisen.

12. Gehäuseschale nach Anspruch 10 oder 11,
**dadurch gekennzeichnet, dass** die mehreren Einsetzmodule (21, 22) derart in die mehreren Modulöffnungen (11, 12) einsetzbar sind, dass dadurch die von Durchgangsöffnungen freie Gehäuseaußenwand (5) gebildet ist, insbesondere dass die mehreren Einsetzmodule (21, 22) derart mit dem Grundkörper (10) der Gehäuseschale (1) verbindbar sind, dass die dabei gebildete Gehäuseaußenwand (5) beim Ausgießen von Gießharz in die Gehäuseschale (1) für das Gießharz dicht ist.

13. Gehäuseschale nach einem der Ansprüche 10 bis 12,
**dadurch gekennzeichnet, dass** zumindest zwischen dem in die erste Modulöffnung (11) eingesetzten ersten Einsetzmodul (21) und dem Grundkörper (10) der Gehäuseschale (1), insbesondere am Rand (13) der ersten Modulöffnung (11) eine Labyrinthdichtung (14) ausgebildet ist.

14. Elektrischer Verteiler mit einer Gehäuseschale (1) nach einem der Ansprüche 1 bis 13,
**dadurch gekennzeichnet, dass** der elektrische Verteiler (9) eine Leiterplatte (2) umfasst, dass die Leiterplatte (2) passive und/oder aktive elektrische Bauelemente (3) trägt, dass die Leiterplatte (2) innerhalb der Gehäuseschale (1) angeordnet ist, dass die Gehäuseschale (1) mit einem Füllmaterial (4) aus einer Spritzgussmasse aus thermoplastischem Elastomer verfüllt ist, dass die Spritzgussmasse in die Gehäuseschale (1) gespritzt ist, dass die Spritzgussmasse die Leiterplatte (2) mit den elektrischen Bauelementen (3) vollständig umschließt, dass die Spritzgussmasse die Leiterplatte (2) mechanisch mit der Gehäuseschale (1) verbindet, und dass die Spritzgussmasse vollständig innerhalb der bis auf die Durchdringungsöffnungen (6) für die Steckkontakte (7) von Durchgangsöffnungen freien Gehäuseaußenwand (5) der Gehäuseschale (1) angeordnet ist.

15. Kunststoffspritzgussverfahren zur Herstellung eines elektrischen Verteilers (9)
- mit einer Gehäuseschale (1) aus einem Kunststoffmaterial, wobei die Gehäuseschale (1) eine Gehäuseaußenwand (5) aufweist, wobei in der Gehäuseaußenwand (5) Durchdringungsöffnungen (6) für Steckkontakte (7) vorgesehen sind, wobei durch jede Durchgangsöffnung (6) ein Stecckontakt (7) gesteckt ist, wobei die Durchdringungsöffnungen (6) durch die Steckkontakte (7) ausgefüllt sind,
- mit einer Spritzgussmasse aus thermoplastischem Elastomer
- und mit einer mit passiven und/oder aktiven elektrischen Bauelementen (3) bestückten Leiterplatte (2),
- mit den folgenden Verfahrensschritten:
• Anordnen der mit den elektrischen Bauelementen (3) bestückten Leiterplatte (2) in der Gehäuseschale (1),
• Anordnen der Gehäuseschale in einer Kavität (30) eines Spritzgusswerkzeugs (31) einer Spritzgießmaschine (32),
• Verflüssigen des Granulats (33) als Rohmaterial des thermoplastischen Elastomers zu einer Schmelze (34) durch Erhitzen des Granulats (33) in einem Heizbereich (35) eines Plastifizierzylinders (35) der Spritzgießmaschine (32) auf eine Heiztemperatur (T) von mindestens 170° C,
• Fördern der Schmelze (34) zu einer geschlossenen Düse (37) des Plastifizierzylinders (36),
• Aufbauen eines Einspritzdrucks (p) von höchstens 500 bar in der Schmelze (34),
• Öffnen der Düse (37) und Einspritzen der Schmelze (34) in die Kavität (30), so dass die Leiterplatte (2) einschließlich der elektrischen Bauelemente (3) mit der Spritzgussmasse umspritzt wird, und die Gehäuseschale (1) mit der Schmelze (34) verfüllt wird,
• Erstarren der Schmelze (34) zur formstabilen Spritzgussmasse,
**dadurch gekennzeichnet, dass** die Gehäuseaußenwand (5) der Gehäuseschale (1), in die die Schmelze (34) eingespritzt wird, mit Ausnahme der Durchdringungsöffnungen (6) vollständig frei von Durchgangsöffnungen ist.
